(19)

Europäisches
Patentamt

European
Patent Office

Office européen
des brevets

(11) **EP 4 453 651 B1**

(12) **EUROPEAN PATENT SPECIFICATION**

(45) Date of publication and mention
of the grant of the patent:
**18.02.2026   Bulletin 2026/08**

(21) Application number: **23714120.5**

(22) Date of filing: **08.03.2023**

(51) International Patent Classification (IPC):
**G03F 1/00** *(2012.01)*        **G03F 1/26** *(2012.01)*
**G03F 1/50** *(2012.01)*        **G03F 7/20** *(2006.01)*

(52) Cooperative Patent Classification (CPC):
**G03F 1/26; G03F 1/00; G03F 1/50; G03F 7/70;
G03F 7/70408**

(86) International application number:
**PCT/NO2023/050051**

(87) International publication number:
**WO 2024/186213 (12.09.2024 Gazette 2024/37)**

(54) **METHOD AND SYSTEM FOR GENERATION OF LITHOGRAPHY PATTERNS**

VERFAHREN UND SYSTEM ZUR ERZEUGUNG VON LITHOGRAPHIEMUSTERN

PROCÉDÉ ET SYSTÈME DE GÉNÉRATION DE MOTIFS DE LITHOGRAPHIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**30.10.2024   Bulletin 2024/44**

(73) Proprietor: **Vestlandets Innovasjonsselskap AS
5006 Bergen (NO)**

(72) Inventors:
• **FIEDLER, Johannes
31134 Hildesheim (DE)**
• **PALAU, Adrià Salvador
08005 Barcelona (ES)**
• **OSESTAD, Eivind Kristen
5055 Bergen (NO)**
• **HOLST, Bodil
5652 Årland (NO)**

(74) Representative: **LIGL IP Consult AS
Apotekergata 10
0180 Oslo (NO)**

(56) References cited:
• **JOHANNES FIEDLER ET AL: "Realistic mask
generation for matter-wave lithography via
machine learning", ARXIV.ORG, CORNELL
UNIVERSITY LIBRARY, 201 OLIN LIBRARY
CORNELL UNIVERSITY ITHACA, NY 14853, 15
July 2022 (2022-07-15), XP091274706, Retrieved
from the Internet <URL:https://arxiv.org/abs/
2207.08723>**
• **FIEDLER JOHANNES ET AL: "An atom passing
through a hole in a dielectric membrane: impact
of dispersion forces on mask-based matter-wave
lithography", JOURNAL OF PHYSICS B, ATOMIC
MOLECULAR AND OPTICAL PHYSICS,
INSTITUTE OF PHYSICS PUBLISHING, BRISTOL,
GB, vol. 55, no. 2, 10 February 2022 (2022-02-10),
XP020415709, ISSN: 0953-4075, [retrieved on
20220210], DOI: 10.1088/1361-6455/AC4B41**
• **NESSE TORSTEIN ET AL: "Nanometer-
Resolution Mask Lithography with Matter Waves:
Near-Field Binary Holography", PHYSICAL
REVIEW APPLIED, vol. 11, no. 2, 5 February 2019
(2019-02-05), XP093084443, Retrieved from the
Internet <URL:https://journals.aps.org/prapplied/
pdf/10.1103/PhysRevApplied.11.024009> DOI:
10.1103/PhysRevApplied.11.024009**

**Description**

TECHNICAL FIELD

The present invention relates to microlithography and the manufacture of integrated circuits and other devices, for example quantum devices which cannot be mass produced with existing technology. More specifically it is related to exposing a mask with a particle beam, generating a particle pattern based on the information coded into the mask and exposing a target, such as a resist on a silicon wafer with the particle pattern.

BACKGROUND

The fabrication of integrated circuits is currently based on pattern generation using mask-based photolithography: An enlarged version of the desired chip pattern or part of the desired chip pattern is printed on a substrate (photomask). The pattern on the mask may be distorted to account for aberration effects etc.. Light (photons) are transmitted through or reflected off the photomask using optical components (refractive or reflective lenses) to create a demagnified image of the pattern on a silicon wafer. The silicon wafer is coated with a photosensitive material (resist), which reacts with the photons thus creating a permanent imprint of the image in the resist. This is then used as a physical mask in the following fabrication steps. The two main light sources used in the semiconductor industry today are Deep Ultraviolet Light (DUV) which has a wavelength of 193 nm and Extreme Ultraviolet Light (EUV) which has a wavelength of 13.5 nm.

The standing aim is to create patterns with smaller and smaller feature sizes at higher and higher information densities, commonly referred to as minimum pitch - the smallest distance between the centres of two features. For a standard optical system, the smallest pitch that can be obtained is half the wavelength of the projecting beam, when the process is performed in air or vacuum (refractive index 1, the Abbe criterion). The performance of DUV is further pushed by using wavefront engineering techniques such as phase shifting masks, off-axis illumination, or optical proximity correction, achieving a minimum pitch of ~30% of the wavelength. The ultimate pitch in DUV lithography is achieved using the Immersion Lithography technique, where a high-refractive index fluid is introduced between the final lens and the wafer. Combining these techniques allows DUV to operate at an effective wavelength of ~135 nm, leading to a minimum pitch of around 38 nm. Additional pitch reduction requires multiple exposures to create one chip pattern, thus decreasing throughput and increasing complexity.

The state-of-the-art is extreme ultraviolet (EUV) photolithography, which, with photons (electromagnetic waves) of a wavelength of 13.5 nm, should be able to produce patterns with a minimum pitch or minimum feature size of around 6.75 nm according to the Abbe criterion with a refractive index of 1 (vacuum).

However, due to the high energy of the photons in EUV lithography, the pattern generation process in the resist is mediated by photo-generated secondary electrons, which can travel for several nm before inducing a reaction. Current experiments and theory indicate that the secondary electron blur radius for EUV is around 3 nm, which would limit the feature size that can be achieved to around 6 nm. This means that quantum devices based on small quantum dots and individual atoms and molecules cannot be produced with EUV. Moving to wavelengths even shorter than 13.5 nm, would just exacerbate the secondary electron issue.

In Berggren, K.K., Bard, A., Wilbur, J.L., Gillaspy, J.D., Helg, A.G., McClelland, J.J., Rolston, S.L., Phillips, W.D., Prentiss, M., Whitesides, G.M.: Microlithography by Using Neutral Metastable Atoms and Self-Assembled Monolayers. Science 269(5228), 1255-1257 (1995) https://arxiv.org/abs/https://www.science.org/doi/pdf/10.1126/science.7652572. https://doi.org/10.1126/science.7652572, lithography with metastable atoms is proposed as an alternative to photolithography. Pattern generation in a thiol-based resist is demonstrated in a proximity lithography setup using a beam of metastable argon atoms transmitted through a grating. In other experiments patterns have been generated with metastable atoms using light masks, in some case with the atoms being directly deposited onto a substrate. However, it has not been demonstrated that atomic beams can be used to generate any desired, complex pattern with a small minimum pitch.

some experiments have been performed to focus atomic beams to a small point with solid state lenses or mirrors or fields. However, this can only be applied for serial writing and is thus unsuitable for mass production.

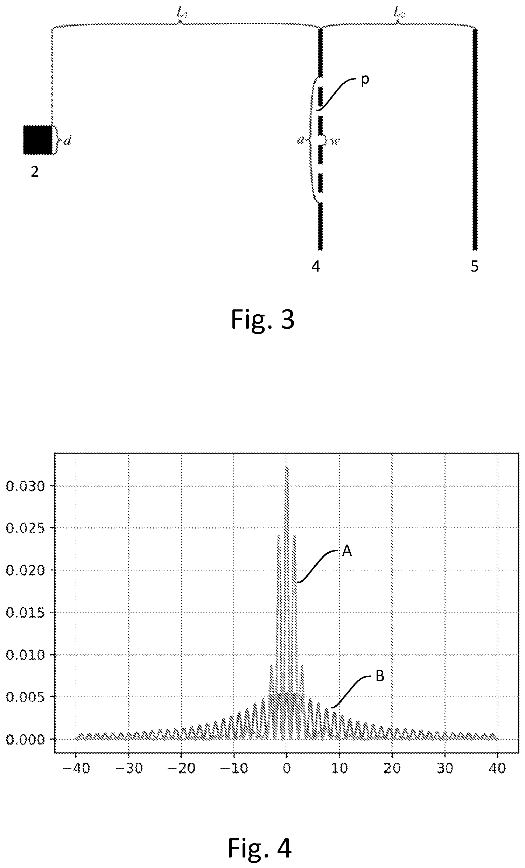

In Fujita, J., Morinaga, M., Kishimoto, T., Yasuda, M., Matsui, S., Shimizu, F.: Manipulation of an atomic beam by a computer-generated hologram. Nature 380(6576), 691-694 (1996). https: https://doi.org/10.1038/380691a0 a desired pattern with metastable neon atoms is generated on a screen, by transmitting the atom beam through a solid mask consisting of a distribution of approximately circular through holes of 30 nm in diameter etched into a silicon nitride membrane. The openings are all of the same size and placed on the membrane at positions defined by a regular, square grid structure. We refer to this approach as grid-based binary holography. The setup operates with all system dimensions within the Fraunhofer regime (far-field) where the Fresnel number F « 1. The mask is designed using a Fourier transform of the desired pattern, so that the diffraction process which takes place during the transmission through the mask, leads to the desired pattern appearing in multiple copies on each side of the 0-order peak. The pattern copies on one side of the 0-order peak are rotated 180° relative to the pattern copies on the other side of the 0-order peak (see figure 4 in the original article).

Nesse, T., Simonsen, I., Holst, B.: Nanometer-Resolution Mask Lithography with Matter Waves: Near-Field Binary Holography. Phys. Rev. Applied 11, 024009 (2019). https://doi.org/10.1103/PhysRevApplied.11.024009 disclosed theoretical work on grid based binary holography with the application of small masks with square and hexagonal grid structures, a distance between the mask and the pattern plane of only $40\mu m$ and very small holes, less than 1 nm.

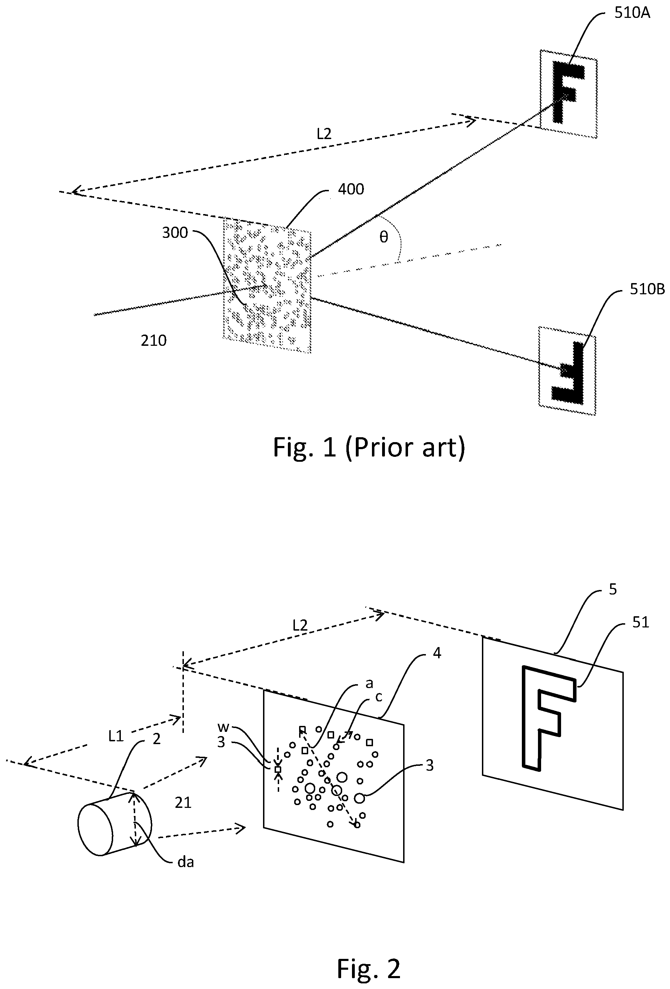

Prior art grid based binary holography, disclosed in some of the publications above and illustrated in Fig. 1 is not suitable for fast generation of patterns with feature sizes below the current state of the art. In particular it is not suitable for creating small features with large masks required for the large write-fields used in the semiconductor industry (typically 29mmx33mm).

JOHANNES FIEDLER ET AL: "Realistic mask generation for matter-wave lithography via machine learning",ARXIV.ORG, CORNELL UNIVERSITY LIBRARY, 201 OLIN LIBRARY CORNELL UNIVERSITY ITHACA, NY 14853, 15 July 2022 (2022-07-15) is directed to a simulation of a pattern generated by a particle beam targeted at a mask with holes. Thereby, dispersion force interaction is taken into consideration.

FIEDLER JOHANNES ET AL: "An atom passing through a hole in a dielectric membrane: impact of dispersion forces on mask-based matter-wave lithography", JOURNAL OF PHYSICS B, ATOMIC MOLECULAR AND OPTICAL PHYSICS, INSTITUTE OF PHYSICS PUBLISHING, BRISTOL, GB, vol. 55, no. 2, 10 February 2022 (2022-02-10) relates to the determination of the effective hole radius (reduction) within which atoms can pass with an accumulated phase shift due to dispersion interaction.

SHORT SUMMARY OF THE INVENTION

Fast generation of patterns with feature size below the limitations of prior art technology is needed to improve the performance of semiconductor devices and enable mass production of a range of quantum devices.

A goal of the present invention is to disclose a system and method for fast generation of patterns with feature sizes down to the nm range.

One of the main advantages of the invention over prior art is that nm features can be generated with nm pitch over large write fields, something which is not possible with prior art technology. Furthermore, nm features can be written using holes that are bigger than the feature sizes, something which has not been demonstrated with binary holography. This may ease production of the masks.

Further advantages of the invention may be that the exposure time can be defined more precisely than in grid based binary holography since the intensity of the patterns in grid based binary holography is not uniformly distributed across and between the patterns. Furthermore, in the invention only one copy of the desired pattern is produced in an exposure, which simplifies the production process before and after pattern generation.

The invention solving the above-mentioned problems is a lithography pattern generation system and a method for generating a pattern by lithography according to the independent claims.

BRIEF DESCRIPTION OF THE DRAWINGS

The above and further advantages of the systems and methods provided in accordance with the invention will now be explained in further detail by way of examples and with reference to the accompanying drawings. The drawings are not necessarily to scale. Instead, certain features may be shown exaggerated in scale or in a somewhat simplified or schematic manner, wherein certain conventional elements may have been left out in the interest of exemplifying the principles of the invention rather than cluttering the drawings with details that do not contribute to the understanding of these principles.

Fig. 1 illustrates pattern generation based on prior art grid based binary holography. Multiple copies of a target pattern (510A, 510B) are generated by the diffraction of an atomic wave (210) passing through a binary holographic mask (400) with holes (300) all of the same size. The open holes are placed at positions corresponding to a grid structure. The grid has a pixel like structure, e.g., 512x512 pixels, where each pixel point may be fully or partially open (through hole) or fully closed. the periodicity of the grid structure, leads to the generation of several copies of two rotated versions of the target pattern of varying intensity at a pattern target distance (L2) behind the mask.

Fig. 2 illustrates schematically a lithography pattern generation system (1) according to an embodiment of the invention. The lithography pattern generation system (1) comprises an incoming particle beam (21) with a most probable wavelength ($\lambda$) from a particle source (2) and a mask (4) arranged in the incoming particle beam (21) between the particle source (2) and a pattern target (5). A generated pattern (51) on the pattern target results from the particles diffracted by the mask (4). The source distance (L1) and the pattern target distance (L2) from the particle source (2) to the mask (4) and from the mask (4) to the pattern target (5) , respectively, are indicated. Further, the mask (4) comprises through holes (3) with a hole width (w) and a mask extension (a), i.e., maximum distance between through holes (3) that are exposed to the incoming particle beam (21).

Fig. 3 illustrates schematically the main components and parameters of a lithography pattern generation system (1) according to an embodiment of the invention in one dimension. References are similar to the ones used in Fig. 2.

Fig. 4 illustrate graphically the Fraunhofer diffraction patterns for a light wave (A) and a metastable helium matter wave (B) with the same wavelength through the same SiN double-slit mask of 5 nm thickness with 8 nm openings separated by an 8 nm wall. The vertical axis is the normalized intensity while the horizontal axis is the position in ($\mu$m). The matter wave has a dispersion force interaction with the dielectric mask, which is not applicable for light waves, resulting in a broadened diffraction pattern with much higher population of higher diffraction orders.

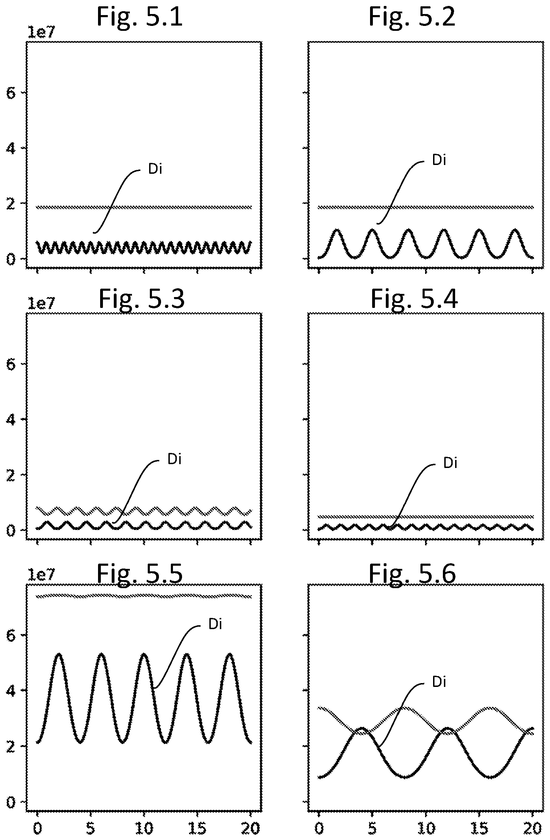

Fig. 5.1, 5.1, 5.3, 5.4, 5.5 and 5.6 illustrate in the vertical direction the atomic flux [atoms/s/m$^2$] in one dimension for each of the sequentially corresponding examples of Table 1 and Table 2. The horizontal line is the position in [nm]. The lower graphs show the flux where the dispersion forces (Di) have been taken into account, while the upper graphs do not consider these forces and thus correspond to the pattern that would be seen if the mask were illuminated with a light beam of similar wavelength to the atom beam. It can be seen that for the atom beam a strong reduction of the 0-order background as well as a higher contrast in the features may be obtained by selecting appropriate system parameters to tune the dispersion forces as further explained below.

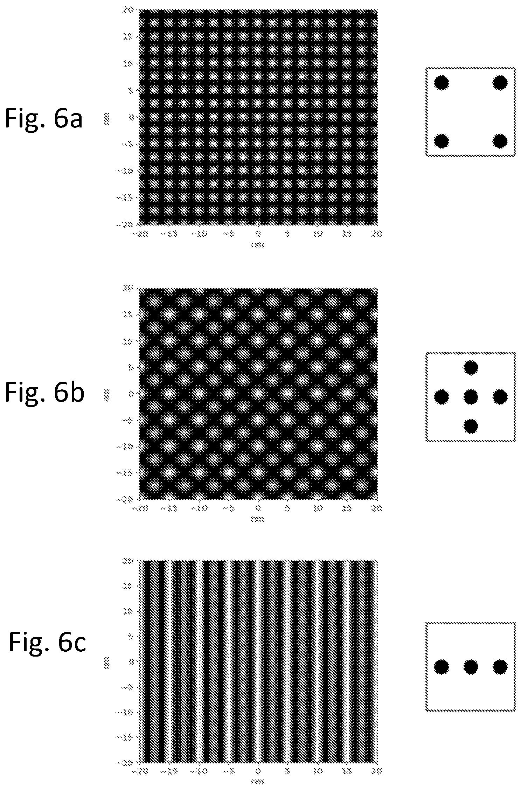

Fig. 6a, 6b and 6c illustrate in sectional views three examples of 2D generated patterns and the mask applied to the right of each respective pattern. The scales in both horizontal and vertical directions are in nm. The feature-size obtained is 1.9 nm in Fig. 6a, 2.5 nm in Fig. 6b and 1.1 nm in Fig. 6c.

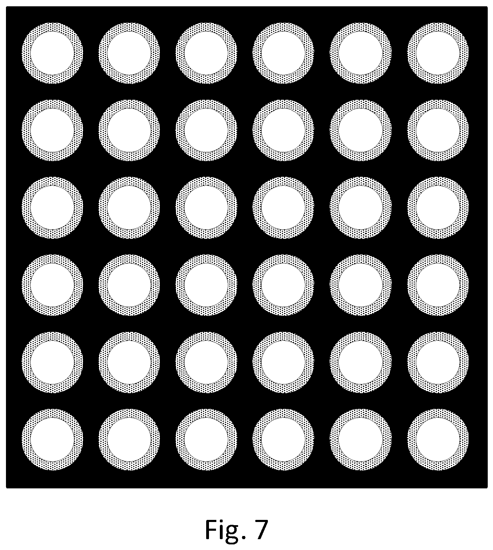

Fig. 7 illustrates an example of a mask with a mask material indicated by the black square. The hatched areas are the absorption regions of the physical through holes where the particles are not transmitted, as explained below. Only the remaining white areas contribute to the diffraction pattern. The drawing corresponds to the situation where the centre of the mask and the centre of the source opening are aligned.

EMBODIMENTS OF THE INVENTION

In the following description, various examples and embodiments of the invention are set forth in order to provide the skilled person with a more thorough understanding of the invention. The specific details described in the context of the various embodiments and with reference to the attached drawings are not intended to be construed as limitations. Rather, the scope of the invention is defined in the appended claims.

The terminology used in the description is intended to be interpreted in its broadest reasonable manner, even though it is being used in conjunction with a detailed description of certain specific implementations of the invention.

For clarity, the terminology used in the document is specified below:

- Binary hologram and binary holography: Traditionally a binary hologram refers to a hologram with areas (openings) that are either fully transparent or fully opaque to the incoming optical (scalar wave) beam. For matter waves the situation is a bit different, since dispersion forces between the matter waves and a dielectric mask may prevent part or all of the matter waves to penetrate the through holes in the mask. Furthermore, the phase is perturbed across the openings. For the purpose of this document, the terms binary holograms and binary holography are also applied for such holograms (masks) when they are exposed by matter waves. In the previous literature on binary holography (theoretical and experimentally) the dispersion force interaction was not taken into consideration. The experimental paper (NATURE cited above) had a target pattern with such big features that the effect of the dispersion forces are not evident.

- Contrast (c): (Imax-Ibackground)/(Imax+Ibackground), where Imax and Ibackground represent the highest and lowest intensity.

- Feature: The smallest piece of information in the pattern. In lithography it is typically an identifiable object in the pattern, such as a line or a dot.

- Feature size: The size of the feature. The feature size may be different in different directions, but in the context of this document the minimum feature size is the most important.

- Fresnel number (F): where

$$F = \frac{a^2}{L_2 \lambda}.$$

- Full width half maximum (d1/2): The distance between points where the intensity reaches half its maximum value.

- Grid period: (g). The minimum distance between two through holes in grid based binary holography. The Grid period will be equal to or larger than the minimum hole width.

- Mask extension (a): The maximum distance between two through holes (3) in the mask (4) plane.

- Minimum hole width (w): The minimum width of a through hole) (3) in the mask (4). Through holes (3) may optionally have different shapes and sizes.

- Opening diameter (da): The diameter of the opening of the particle source (2), defined for a supersonic source as the fraction of the virtual source retained by a collimating aperture. The virtual source is defined in the literature as the intensity distribution which can be obtained by backtracking the atoms leaving the quitting surface to a minimum area. The quitting surface is the point at which the particles can be said to move in free molecular flow, not interacting with each other. See for example:; https://www.researchgate.net/publication/356510630_Neutral_Helium_Microscopy_ SHeM_ A_Review. For an effusive source, the opening of the particle source is simply the hole between the particle reservoir and the vacuum, or a collimating aperture placed downstream from that hole.

- Pattern target (5): An object arranged in the diffracted particle pattern opposite the particle source (2) with regards to the mask (4). For integrated circuit production this could typically be a silicon wafer coated with resist. Formulation for resists suitable for helium atoms are presented in the literature, for example in the Berggren et al paper cited above.

- Pitch: The distance between the centres of two adjacent features.

- Resolution: The minimum pitch that can be transferred to the substrate.

- Source distance (L1): The distance between the particle source (2) and the mask (4). More specifically it can be said to be the distance from the particle source (2) opening to the front of the holography mask (4).

- Pattern Target distance (L2): The distance from the mask (4) to the pattern target (5). More specifically it can be specified as the distance from the back of the mask (4) to the pattern target (5).

- Throughput: is the number of substrates or wafers that can be exposed per hour and is thus a measure of the efficiency of the lithographic process.

- Wavelength (λ): The most probable wavelength of the particles in the incoming particle beam (21) from the particle source (2). The particle source may have a skewed wavelength distribution.

Prior art conventional binary holography used with atomic beams mentioned initially and illustrated in Fig.1, is based on a holographic mask with uniformly sized holes arranged according to an underlying grid structure. This has several implications on the generated pattern.

First of all, different diffraction orders have different intensities, determined by the size and shapes of the through holes and the grid period, which means that the exposure time cannot be optimized for all parts of the generated pattern(s).

Secondly, the target patterns (510A, 510B) as illustrated in Fig. 1 are oriented differently, which complicates production steps before, during and after pattern generation.

Third, the pattern target distance (L2) must be sufficiently large to prevent that the 0-order beam and the target patterns overlap with each other.

The minimum pattern target distance (L2) may be derived from the angular position, θ of the first-order peak in the pattern target plane, relative to the centre of the first order peak determined by the underlying grid structure. The angle θ is measured relative to the surface normal of the mask plane, see Fig. 1.

$$\sin \theta = \lambda/g$$

The centre position of the target pattern closest to the 0-order peak (the centre position of the first-order peak) in the pattern target plane is (here the small angle approximation has been applied):

$$(\lambda/g)L2$$

For the first-order diffraction not to overlap with the 0-order diffraction, the centre of the 1-order peak must be at a distance a from the centre, in order not to overlap with the 0-order peak which will have the mask extension (a), regardless of the distance to the mask, because it consists of all the atoms that go straight through. We thus have that

$$(\lambda/g)L2 \geq a \rightarrow L2 \geq ga/\lambda \geq wa/\lambda$$

We see that the larger the mask, the larger the minimum pattern target distance L2 has to be.

In a first independent system embodiment ES1-1, the invention is a lithography pattern generation system (1) comprising;

- an incoming particle beam (21) with a wavelength ($\lambda$) from a particle source (2) and
- a mask (4) comprising through holes (3) arranged in the incoming particle beam (21), wherein the lithography pattern generation system (1) is configured to generate a pattern (51), on a pattern target (5).

In a system embodiment ES1-2, of ES1-1, the particles in the incoming particle beam (21) arrives at the mask (4) in an incoming particle wave, wherein the mask (4) is configured to induce phase shifts of the particle wave front as it propagates through the mask.

In a system embodiment ES1-3, of ES1-1 or ES1- 2, the induced phase shift is at least $\pi$, $3/2\pi$ or $5/3\pi$ for a distance 0.016 times a minimum hole width (w) of the through holes (3) from the mask (4).

The minimum hole width (w) is the minimum hole width of the through holes (3) in the mask (4).

In a system embodiment ES1-4, of any of ES1-1 to ES1-3, the particles in the incoming particle beam (21) arrives at the mask (4) in an incoming particle wave, wherein the mask (4) is configured to modulate the amplitude of the particle wave front as it propagates through the mask.

In a system embodiment ES1-5, of any of ES1-1 to ES1-4, the lithography pattern generation system (1), is configured to generate a single copy of the pattern (51).

In a system embodiment ES1-6, of ES1-1 or ES1-5, wherein the lithography pattern generation system (1) is configured to generate the pattern (51) a target distance (L2) from the mask (4) on the opposite side of the incoming particle beam (21).

In a system embodiment ES1-7, of any of ES1-1 to ES1-6, wherein the through holes (3) have been tuned to have an effective opening size ($w_e$) smaller than the physical hole width (w) of the through holes (3) by adjusting the dispersion forces interaction between the incoming particle beam and (21) the mask (4).

In a system embodiment ES1-8, of any of ES1-1 to ES1-7, wherein parameter values for physical hole width (w), mask material and mask thickness are selected to induce phase shifts of the incoming particle wave front by modifying dispersion forces interaction between the incoming particle beam and (21) the mask (4).

In a system embodiment ES1-9, of any of ES1-1 to ES1-8, wherein the mask (4) is doped or implanted with any of neutral particles, ions and electrons to modify the dispersion forces interaction and /or the Debye forces interaction to modify the phase shifts across the wavefront.

In a system embodiment ES1-10, of any of ES1-1 to ES1-9, wherein the lithography pattern generation system (1) is configured to reduce the background signal (the fraction of the signal going straight through) so that the fraction of the beam that is diffracted is bigger than that of an optical wave propagating with the same wavelength through the same mask (4) in a direction axially through a through hole (3), to e.g., increase the contrast (c) of the pattern (51).

In general the overall transmitted signal for particles is reduced more than for an optical signal. But the reduction of the background signal (the fraction of the signal going straight through) is stronger than the reduction of the diffracted signals.

In a system embodiment ES1-11, of any of ES1-1 to ES1-10, the through holes (3) have a minimum hole width (w) and a mask extension (a) which is the maximum distance between two through holes in the mask (3) exposed by the incoming particle beam (21), wherein;

$$L2 < \frac{wa}{\lambda}$$

In a system embodiment ES1-12, of any of ES1-1 to ES1-11, the particle source (2) has an opening diameter (da)

that is smaller than a source distance (L1) between the particle source (2) and the mask (4).

In a system embodiment ES1-13, of any of ES1-1 to ES1-12, the mask extension (a) is smaller than a source distance (L1) between the particle source (2) and the mask (4).

In a system embodiment ES1-14, of any of ES1-1 to ES1-13, the mask and the pattern target (5) are arranged in parallel.

In a system embodiment ES1-15, of any of ES1-1 to ES1-13, the mask and the pattern target (5) are arranged in non-parallel.

In a system embodiment ES1-16, of any of ES1-1 to ES1-15, the mask is curved.

In a system embodiment ES1-17, of any of ES1-1 to ES1-16, any of the mask (4) and pattern target (5) is tilted relative to the particle source (2).

In a system embodiment ES1-18, of any of ES1-1 to ES1-17, the centre of the particle source (2) is shifted relative to the centre of the mask (4).

Tilted masks will introduce an asymmetry in the diffraction pattern, a curved mask may be configured to equalize the population of the diffraction orders and, thus, supporting the illumination of the entire pattern target (5).

In a system embodiment ES1-19, of any of ES1-1 to ES1-18, the minimum hole width (w) is at least two times, three times or four times as large as a minimum feature-size of the pattern (51).

In a system embodiment ES1-20, of any of ES1-1 to ES1-19, the mask (4) is a binary holography mask.

In a system embodiment ES1-21, of any of ES1-1 to ES1-20, the mask (4) is made in a dielectric material.

In a system embodiment ES1-22, of any of ES1-1 to ES1-21, the mask (4) comprises silicon nitride, $Si_3N_x$ or $Si_3N_4$.

In a system embodiment ES1-23, of any of ES1-1 to ES1-22, the through holes (3) are not arranged according to a predefined underlying periodic grid structure on the mask (4)

In a system embodiment ES1-24, of any of ES1-1 to ES1-23, the through holes (3) have non-uniform minimum hole widths (w).

In a system embodiment ES1-25, of any of ES1-1 to ES1-24, the through holes (3) have a minimum hole width (w) of 5nm, 4nm, 3nm, 2nm or 1nm.

Hole sizes below 5nm can be realized in 2d materials.

In a system embodiment ES1-26, of any of ES1-1 to ES1-25, the through holes (3) have a maximum hole width (w) of 100 nm.

In a system embodiment ES1-27, of any of ES1-1 to ES1-26, the through holes (3) have different hole widths (w).

In a system embodiment ES1-28, of any of ES1-1 to ES1-27, the through holes (3) have different shapes.

In a system embodiment ES1-29, of any of ES1-1 to ES1-28, the centre-to-centre distance (c) between neighbouring through holes (3) is non-uniform.

In a system embodiment ES1-30, of any of ES1-1 to ES1-29, the mask thickness is below 500 nm, 100 nm, 50nm, 20 nm, 10 nm or 7 nm.

In a system embodiment ES1-31, of any of ES1-1 to ES1-30, the mask thickness is less than the minimum hole width (w).

In a system embodiment ES1-32, of any of ES1-1 to ES1-31, the particle beam (21) comprises metastable atoms or molecules.

In a system embodiment ES1-33, of any of ES1-1 to ES1-32, the particle beam (21) comprises metastable noble gas atoms.

In a system embodiment ES1-34, of any of ES1-1 to ES1-33, the particle beam (21) comprises metastable helium atoms.

In a system embodiment ES1-35, of any of ES1-1 to ES1-34, the wavelength ($\lambda$) is smaller than any of the minimum feature-size (df), minimum pitch, minimum hole width (w) and mask thickness.

In a system embodiment ES1-36, of any of ES1-1 to ES1-35, the wavelength ($\lambda$) is below 1.0 nm, 0.5 nm, or 0.2nm.

In a system embodiment ES1-37, of any of ES1-1 to ES1-36, the lithography pattern generation system (1) is configured to generate the pattern on the pattern target (5) in a single exposure.

In a system embodiment ES1-38, of any of ES1-1 to ES1-37, the lithography pattern generation system (1) comprises the particle source (2).

In a system embodiment ES1-39, of any of ES1-1 to ES1-38, the lithography pattern generation system (1) comprises the pattern target (5).

In a system embodiment ES1-40, of any of ES1-1 to ES1-39, the particle source (2) is supersonic or effusive.

In a system embodiment ES1-41, of any of ES1-1 to ES1-40, the mask (4) is made based on the mask model generated according to any of the computer implemented methods EC1-1 to EC1-6 below.

In a first independent method embodiment EM1-1, the invention is a method for generating a pattern (51) by lithography comprising;

- exposing a mask (4) comprising through holes (3) to an incoming particle beam (21) from a particle source (2).

In a method embodiment EM1-2, of EM1-1, particles in the incoming particle beam (21) arrives at the mask (4) in a particle wave, wherein the mask (4) is configured to induce a phase shift of the particle wave as it propagates through the mask.

In a method embodiment EM1-3, of EM1-1 or EM1-2,, the induced phase shift is at least $\pi$, $3/2\pi$ or $5/3\pi$ for a distance 0.016 times a minimum hole width (w) of the through holes (3) from the mask (4).

In a method embodiment EM1-4, of any of EM1-1 to EM1-3, the method comprises;

- arranging the mask (4) in front of a pattern target (5) and generating the pattern (51) on the pattern target (5).

In a method embodiment EM1-5, of any of EM1-1 to EM1-4, wherein the pattern target (5) is arranged a target distance (L2) from the mask, the through holes (3) have a minimum hole width (w) and the mask (4) has a mask extension (a) between the through holes (3) exposed by the incoming particle beam (21), and wherein;

$$L2 \leq \frac{wa}{\lambda}$$

In a method embodiment EM1-6, of any of EM1-1 to EM1-5, the through holes (3) have an effective hole width ($w_e$) smaller than the minimum hole width (w) due to dispersion forces between the incoming particle beam and (21) the mask (4).

In a method embodiment EM1-7, of any of EM1-1 to EM1-6, the method is performed on the lithography pattern generation system (1) of any of ES1-1 to ES1-40.

In a method embodiment EM1-8, of any of EM1-1 to EM1-7, the method comprises generating the mask model according any of EC1-1 to EC1-6.

In a method embodiment EM1-9, of any of EM1-1 to EM1-8, the method comprises manufacturing a mask based on the mask model generated in any of the computer implemented method embodiments EC1-1 to EC1-6.

A specific independent embodiment of the invention will now be disclosed with reference to Fig. 2.

In this embodiment the invention is a lithography pattern generation system (1) comprising an incoming metastable helium atom beam (21) with a most probable wavelength ($\lambda$) from a particle source (2) and a mask (4) comprising through holes (3) arranged in the incoming particle beam (21).

Contrary to the mask (400) in Fig. 1 for prior art lithography pattern generation systems, where the through holes (300) are arranged according to a pre-defined underlying grid structure, independent of the target pattern, the through holes (3) according to the invention are not arranged on the mask according to a pre-defined underlying grid structure (4). Further, the holes (3) may have different shapes and different minimum hole widths (w). A single pattern with minimum feature size down to 1 nm or less (51) is generated on a pattern target (5) arranged at a target distance (L2) from the mask (4).

The invention takes advantage of the perturbation of the particle wave by the dispersion forces interaction between the dielectric mask and the particle itself when it passes through a hole in the mask. The dispersion forces, in particular the Casimir-Polder forces, are caused by the quantum-mechanical ground-state fluctuations of the electromagnetic field in the absence of charges. Due to the field fluctuations, the metastable helium atoms will be polarized for a short amount of time. The resulting induced dipole moment then interacts with the mask via dipole-dipole interactions. These forces decay with the distance, $r^{-3}$-power law, but play a significant role on the nanometre length scale. The interaction is stronger closer to the edge of the hole and weaker towards the middle. This leads to a reduction of the number of atoms going straight through. In the Fraunhofer diffraction regime this has the effect of a reduced 0-order d peak and a broadened diffraction pattern as illustrated in Fig. 4.

In this embodiment metastable helium atoms passes through holes in the mask which is a silicon nitride membrane. The dispersion forces prevent a very large fraction of the metastable helium atoms with a wavelength of 0.1 nm to penetrate holes with a diameter less than 2nm in 5 nm thick silicon nitride masks.

The dispersion force interaction has a positive effect of the contrast of the generated patterns.

The difference in contrast may be exemplified by looking at a one-dimensional set of key system parameters. Table 1 below shows examples of parameter values for a system realisation taking dispersion forces into account (assuming metastable helium and a 5 nm thick silicon nitride mask), and for a scalar wave system realisation). Table 2 shows the resulting parameter values for the two systems. It is worth noting from Table 1 that all examples are within in the range of $L2 \leq wa/\lambda$, where first-order diffraction overlap with the 0-order diffraction for prior art.

Table 1: Parameters used to compare feature sizes of a system taking the dispersion forces into account, and a system not taking these features into account. A dispersion force profile for a standard 5 nm thick SiN wafer and metastable helium atoms is used. The patterns are three slits one at each edge of the mask and one in the middle. In addition, although the Fresnel number varies considerably, for all examples the condition $L2 \leq wa/\lambda$ is fulfilled as can be seen from the last column.

| Example | $L1$ | $L2$ | $w$ | $\lambda$ | $a$ | F | L2 versus $wa/\lambda$ |
|---|---|---|---|---|---|---|---|
| 1 | 1.5m | 600$\mu$m | 10nm | 0.05nm | 48$\mu$m | 76800 | 6,25 % |
| 2 | 1.5m | 600$\mu$m | 10nm | 0.05nm | 12$\mu$m | 4800 | 25,00 % |
| 3 | 1.5m | 1000$\mu$m | 10nm | 0.05nm | 36$\mu$m | 25920 | 13,89 % |
| 4 | 1.5m | 1200$\mu$m | 10nm | 0.05nm | 60$\mu$m | 60000 | 10,00 % |
| 5 | 1.5m | 600$\mu$m | 20nm | 0.05nm | 10$\mu$m | 3333 | 15,00 % |
| 6 | 1.5m | 1200$\mu$m | 25nm | 0.05nm | 10$\mu$m | 1667 | 24,00 % |

Table 2: Results of the parameters for the system of Table 1, for full width half maximum: (d1/2) (-), and Contrast: (c) (-) without dispersion forces and corresponding parameters (d1/2) (Di), and (c) (Di) with the dispersion forces.

| Example | $d1/2$ (-) | $d1/2$ (Di) | $c$ (-) | $c$ (Di) |
|---|---|---|---|---|
| 1 | 0.53nm | 0.75nm | 0.0024 | 0.20 |
| 2 | 2.18nm | 3.08nm | 0.0007 | 0.40 |
| 3 | 1.50nm | 1.65nm | 0.26 | 0.71 |
| 4 | 1.05nm | 0.98nm | 0.0028 | 0.11 |
| 5 | 3.45nm | 3.15nm | 0.15 | 0.41 |
| 6 | 6.15nm | 6.60nm | 0.16 | 0.68 |

It is worth looking specifically at the two columns for contrast. It can be seen that the contrast has increased considerably for all examples with comparable feature-sizes when the dispersion forces are taken into account. These results are also illustrated graphically in Fig. 5.1 to F.6.

The invention allows the most probable ($\lambda$) of the particles in the incoming particle beam to be small compared to other critical dimensions such as e.g., feature size (df), minimum distance between features (d1/2), mask extension (a) as well as source and pattern target distance (L1, L2).

Since the most probable wavelength ($\lambda$) can be chosen to be small compared to the desired feature size (df), the pattern can be generated using a beam with the velocity spread of a supersonic or effusive source. The slight blur this introduces in the pattern is not a problem. The wavelength is given by the velocity and vice versa through the de Broglie equation.

The contrast in the diffraction pattern can be modified by changing the dispersion force influence through one of the following means: Changing the size of the holes, changing the shape of the hole changing the thickness of the mask material (the membrane), changing the material of the mask, doping the mask by electron or ion implantation or surface functionalization or changing the metastable atom or molecule.

Fig. 6a, 6b and 6c illustrate in an embodiment of the invention sections of three 2D patterns generated in the setups listed in Example 1, 2 and 3 in Table 3 below. To the right of each figure is an illustration of the mask applied, where the size of the mask is 10$\mu$m$\times$10$\mu$m with 10nm circular through holes. A dispersion force profile for a standard 5 nm thick SiN wafer and metastable helium atoms is used. The repetitive patterns are generated by through holes arranged in a 3$\times$3 grid with a hole spacing of 6$\mu$m. It is worth noting that the hole width (w) in the mask are from 4 to 9 times larger than the features sizes in the generated pattern.

Table 3: Information about the setup and the features of the 2D pattens generated in the examples illustrated in Fig. 6a, 6b and 6c. The parameters are the same as in Table 1 and 2.

| Ex. | $L1$ | $L2$ | $w$ | $\lambda$ | $a$ | $d_{1/2}$ (Di) | Df (Di) | C (Di) | F |
|---|---|---|---|---|---|---|---|---|---|
| 1 | 1.5m | 600$\mu$m | 10nm | 0.05nm | 12$\mu$m | 0.6nm | 1.9nm | 0.97 | 4800 |
| 2 | 1.5m | 600$\mu$m | 10nm | 0.05nm | 12$\mu$m | 0.9nm | 2.5nm | 0.68 | 4800 |
| 3 | 1.5m | 600$\mu$m | 10nm | 0.05nm | 12$\mu$m | 1.4nm | 1.1nm | 0.36 | 4800 |

The desired 2D patterns are here periodic, which gives a periodic mask structure as seen in in Fig. 6a, 6b and 6c.

The diffraction pattern is determined by Kirchhoff's diffraction formula with the transmission function for neutral matter waves

$$P(r) = \frac{a^2}{4\pi^2} \int \mathrm{d}\lambda_0 f(\lambda_0; \lambda, \Delta\lambda)$$

$$\times \int_{oda} \mathrm{d}^2 s \left| \int \mathrm{d}^2 s_m g_{L2}(r - s_m) \exp\left[ -i\frac{27\pi C_3 m\lambda_0 d}{16h^2} \int \frac{\mathrm{d}^2 s_{m'}}{|s_{m'} - s_m|^5} \right] g_{L1}(s_m - s) \right|^2$$

with the wave's amplitude and the wave propagators $g_X(r_2 - r_1)$ from the source point $r_1 = s, s_m$ to the final point $r_2 = s_m, r$ along the distance $X = L1, L2$. This equation has to be read from right to left: the matter wave propagates from a point in the source plane $s$ to a point in the mask plane $s_m$ along the distance $L1$, where it collects phase shifts across the wavefront due to the dispersion forces, here the Casimir-Polder interaction in the non-retarded limit, which depends on the interaction strength $C_3$ between the mask material and the particle, the mass of the beam particle $m$, the wavelength $\lambda_0$, the mask's thickness $d$, the Planck constant $h$, and the mask's shape expressed by the integral over the mask's surface; afterwards the propagation continues to a point in the pattern target plane $r$ along the propagation length $L2$. The interference is described by the superposition of all optical paths from the source $s$ to the pattern target $r$ determined by the square of the absolute value. As each particle interferes only with itself, different initial conditions, such as other source points $s$ or with a different wavelength (respectively particle's velocity), will yield an incoherent superposition. Thus, the interference of all states have to be averaged incoherently leading to the integral over the source area and over the wavelength distribution $f(\lambda_0; \lambda, \Delta\lambda)$ with the most probable wavelength $\lambda$ and wavelength distribution $\Delta\lambda$.

The formula above needs to be modified to account for tilted or curved mask and/or pattern target.

There are two integrals inside the mask plane: one for the coherent superposition $s_m$ and one for the phase shift $s_{m'}$. The first integral (over $s_m$) describes the optical paths and is over the hole's area. The other one (over $s_{m'}$) describes the interaction with the mask material and, thus, represents the bulk material. Fig. 7 illustrates these two different areas for a section of a mask with regular spherical holes. The mask material is depicted by the dark area and denotes the area for the phase shift integral $s_{m'}$. The physical holes are the white and grey areas, where the latter is the absorption region, defined as the region where the atoms are not transmitted, and thus, does not contribute to the optical paths. Only the white area is relevant for the coherent superposition.

Kirchhoff's diffraction formula describes the most general case of interference. There are different approximations for the propagator leading to simplifications valid in different regimes. They are summarized in table 4. It can be seen that the propagator simplifies to the Fourier transform in the Fraunhofer and Fresnel regimes due to the cancelation of the dependencies in the denominator, used for all previous publications on matter-wave lithography. We consider the wave propagator between the mask and the target ($g_{L2}$) to achieve the resolution and the Fraunhofer regime between the source and the mask ($g_{L1}$) to achieve the stability concerning source extension and wavelength variations.

| | $g_{L1}(s_m - s)$ |
|---|---|
| Wave propagator, $F \leq 0$ | $e^{i\frac{2\pi}{\lambda_0}\sqrt{L1^2 + (x_m - s_x)^2 + (y_m - s_y)^2}}$ $\sqrt{L1^2 + (x_m - s_x)^2 + (y_m - s_y)^2}$ |
| Fraunhofer regime, $0 \leq F \ll 1$ | $e^{i\frac{2\pi}{\lambda_0}L1}$ |
| Fresnel regime, $F \simeq 1$ | $e^{i\frac{2\pi}{\lambda_0}L1}$ |

Table 4: Overview of the wave propagators for the different regimes (Fraunhofer regime, Fresnel regime, wave propagator).

| | $g_{L2}(r - s_m)$ |
|---|---|
| Wave propagator, $F \leq 0$ | $$\dfrac{e^{i\frac{2\pi}{\lambda_0}\sqrt{L2^2 + (s_x - r_x)^2 + (s_y - r_y)^2}}}{\sqrt{L2^2 + (s_x - r_x)^2 + (s_y - r_y)^2}}$$ |
| Fraunhofer regime, $0 \leq F \ll 1$ | $$\frac{1}{L2}e^{i\frac{2\pi}{\lambda_0}\left(L2 + \frac{r_x^2 + r_y^2}{2L2}\right)}e^{-i\frac{2\pi}{\lambda_0 L2}(s_x r_x + s_y r_y)}$$ |
| Fresnel regime. $F \simeq 1$ | $$\frac{1}{L2}e^{i\frac{2\pi}{\lambda_0}\left(L2 + \frac{r_x^2 + r_y^2}{2L2}\right)}e^{i\frac{2\pi}{\lambda_0 L2}(s_x^2 + s_y^2)}e^{-i\frac{2\pi}{\lambda_0 L2}(s_x r_x + s_y r_y)}$$ |

The properties of the mask (4), such as hole width (w), mask extension (a), hole arrangement and mask material and thickness will determine the generated pattern. However, the generated pattern, or desired pattern, will in real life situations be determined by the circuit design of the manufactured items, such as e.g. integrated circuits. It is therefore necessary to produce the mask based on the desired pattern. This is often referred to as the inverse problem.

As discussed above, existing binary holography theory for scalar waves, uses a grid of holes with equal size as the base for the masks and assumes system dimensions and wavelength that fulfil the well-known optics condition of Fraunhofer approximation. In the Fraunhofer approximation the inverse problem is reduced to a Fourier transform of the desired pattern, which yields the required mask. Sampling the mask according to the Nyquist-Shannon sampling theorem provides its mode's bandwidth and thus the possible minimum pitch. In one dimension, this can be done analytically as described in prior art. This may to also work for matter waves if the holes in the mask are so large that the dispersion force interaction is negligible.

However, the above cannot be adapted to matter waves and masks with smaller holes required for small pitch, because the dispersion force interaction between the particles and the diffraction object induces a complex phase distribution of the matter wave as explained above, which is not accounted for in the prior art mask generation theories.

According to an embodiment of the invention, an alternative way of producing mask structures based on machine learning is disclosed below.

A deep convolutional neural network or any model representing a differentiable, nonlinear function is used to approximate a general solution to the inverse problem. This neural network is trained with a large data set of randomly generated examples that map a mask to a pattern by applying Kirchhoff's diffraction formula as explained above. Masks may be represented as binary sequences or arrays of finite length where 1 represents through holes in the mask and 0 blocked space. The patterns may in one implementation also be represented by similar binary sequences or arrays, where the pattern target can be defined as a fine grid, where the distance between grid lines is smaller than the desired feature size.

Once the approximate solution is obtained, which is a binary mask it can be further refined until producing a solution with the desired accuracy by using a genetic algorithm or any other optimization algorithm based on maximizing a fitness or reward function. both gradient free and non-gradient free algorithms can be used.

Genetic algorithms are stochastic classical evolutionary algorithms, that is algorithms that dynamically change in order to optimize a fitness function F. Genetic algorithms are inspired by Darwin's theory of evolution that describes how the genes in the population evolve according to their capacity of reproducing and mutating. In genetic algorithms, the population is not an actual population of living beings but instead a set of solutions for a particular optimization problem (known as chromosomes). Furthermore, mutation is not necessarily the result of natural stochastic processes but occurs according to different rules that can be decided during implementation. For each chromosome in the population a fitness value can be calculated using a pre-defined formula set at the choice of the researcher. Finally, the reproductive process of life is simulated by combining different chromosomes (parents) into next generations of offspring. Genetic algorithms are very robust optimization algorithms that are especially suited to work with sequences of categorical variables, such as e.g., the bases present in DNA. The masks used here are fully defined by a sequence or array of binary values.

The fitness function is the inverse of the mean absolute error of the generated diffraction pattern plus a small numerical constant a.

$$F = \frac{1}{\alpha + \sum_{r_i} |\check{P}(r_i) - \psi(r_i; \boldsymbol{x}, \boldsymbol{d})\psi^*(r_i; \boldsymbol{x}, \boldsymbol{d})|}.$$

$\check{P}$(ri) is the absolute square value of the wave function discretised over a grid of radial coordinates ri measuring the distance to the centre of the diffraction pattern. $\Psi$(ri; **x; d)** is the wave function that is made to depend on the positions **x** = (x1; x2; : : : ) and thicknesses **d** = (d1; d2; : : : ) of the mask openings.

The deep neural network may be implemented in an available software library, such as TensorFlow with the Keras module available from https://www.tensorflow.org/ or pytorch.

The genetic algorithm may be implemented with pygad: https://pygad.readthedocs.io/en/latest/#. Other optimisation algorithms can be implemented for example using nevergrad: https://facebookresearch.github.io/nevergrad/.

In an independent embodiment EC1-1, the invention is a computer implemented method for generating a lithography mask model, comprising;

- generating training masks comprising through holes, wherein properties of the training masks are output variables to a machine learning algorithm,
- generating the training patterns based on the generated training masks, wherein properties of the training patterns are input parameters of the machine learning algorithm,
- generate the lithography mask structure based on a desired pattern by feeding the desired pattern into the machine learning algorithm.

The properties of the training masks may be dependent on the properties of the particle source, such as wavelength, opening diameter, velocity spread etc.

The lithography mask model generated by the method is a model of the real mask (4) that will be produced later based on the model, while the training masks are mask models used only to train the machine learning algorithm. The desired pattern is the result of e.g., the design of the circuit that is going to be produced when the real mask (4) is exposed to the incoming particle beam (21) resulting in the generated pattern (51). The generated pattern (51) should be as identical to the desired pattern as possible.

In a dependent embodiment EC1-2, which may be combined with EC1-1, any of a position, a hole width and a hole shape for the through holes are properties of the training masks that are generated randomly or partially randomly. Thus, the method allows a lot of freedom when creating training masks. This will also be reflected in the generated mask models and the final masks, since there is in general no need for a grid - or repetitive structure to create the desired pattern as long as the pattern is not itself periodic.

In a dependent embodiment EC1-3, which may be combined with EC1-1 or EC1-2, the machine learning algorithm comprises a supervised machine learning algorithm.

In a dependent embodiment EC1-4, which may be combined with any of EC1-1 to EC1-3, the supervised machine learning algorithm comprises a deep neural network.

In a dependent embodiment EC1-5, which may be combined with any of EC1-1 to EC1-4, the computer implemented method for generating a lithography mask model, comprises manufacturing a mask (4) comprised in any of ES1 to ES40, based on the generated lithography mask model.

After Masks structure has been generated, the physical mask may be manufactured according to the parameters obtained as a result of the machine learning process above. Mask production may be performed according to prior art by e.g. etching of the holes, and is not within the scope of this application. However, as indicated above, the invention allows small feature sizes to be obtained with relatively larger hole sizes compared to prior art, which may ease production of the masks resulting in faster and cheaper mask production.

In a dependent embodiment EC1-6, which may be combined with any of EM1-1 to EM1-5, the computer implemented method for generating a lithography mask model comprises manufacturing a mask (4) comprised in any of ES1 to ES40, based on the generated lithography mask model.

In the exemplary embodiments, various features and details are shown in combination. The fact that several features are described with respect to a particular example should not be construed as implying that those features by necessity have to be included together in all embodiments of the invention. Conversely, features that are described with reference to different embodiments should not be construed as mutually exclusive. As those with skill in the art will readily understand, embodiments that incorporate any subset of features described herein and that are not expressly interdependent have been contemplated by the inventor and are part of the intended disclosure. However, explicit description of all such embodiments would not contribute to the understanding of the principles of the invention, and consequently some permutations of features have been omitted for the sake of simplicity or brevity.

**Claims**

1. A lithography pattern generation system (1) comprising

 - an incoming particle beam (21) with a wavelength, $\lambda$, from a particle source (2) and
 - a mask (4) comprising through holes (3) arranged in the incoming particle beam (21), wherein the lithography pattern generation system (1) is configured to generate a pattern (51) on a pattern target (5), wherein particles in the incoming particle beam (21) arrives at the mask (4) in an incoming particle wave, and wherein the mask (4) is configured to induce phase shifts across a wave front of the particle wave as it propagates through the mask, wherein the lithography pattern generation system (1) is configured to generate the pattern (51) at a target distance, L2, from the mask (4) on the opposite side of the incoming particle beam (21), wherein the through holes (3) have a minimum hole width, w, and the mask (4) has a mask extension, a, which is the maximum distance between two through holes in the mask (4) exposed by the incoming particle beam (21), **characterized in that** L2 $\leq$ wa/$\lambda$.

2. The lithography pattern generation system (1) of claim 1, wherein the induced phase shift is at least $\pi$, $3/2\pi$ or $5/3\pi$ for a distance 0.016 times a minimum hole width, w, of the through holes (3) from the mask (4).

3. The lithography pattern generation system (1) of any of claims 1 to 2, wherein the mask (4) is doped or implanted with any of neutral particles, ions and electrons to modify the dispersion forces interaction to modify the phase shifts across the wavefront.

4. The lithography pattern generation system (1) of any of claims 1 to 3, configured to reduce the background signal stronger than the diffraction orders compared to the diffraction of an optical wave propagating with the same wavelength through the same mask (4) in a direction axially through a through hole (3), to increase the fraction of the beam that is diffracted rather than passing straight through the contrast, c, of the pattern (51).

5. The lithography pattern generation system of any of claims 1 to 4, wherein the particle source (2) has an opening diameter, da, that is smaller than a source distance, L1, between the particle source (2) and the mask (4).

6. The lithography pattern generation system of any of claims 1 to 5, wherein the mask extension (a) is smaller than a source distance, L1, between the particle source (2) and the mask (4).

7. The lithography pattern generation system (1) of any of claims 1 to 6, wherein the minimum hole width, w, is at least two times, three times or four times as large as a minimum feature-size of the pattern (51).

8. The lithography pattern generation system (1) of any of claims 1 to 7, wherein the mask (4) is a binary holography mask.

9. The lithography pattern generation system (1) of any of claims 1 to 8, wherein the through holes (3) are arranged in non-periodic positions on the mask (4), not according to a predefined underlying periodic grid structure.

10. The lithography pattern generation system (1) of any of claims 1 to 9, wherein the through holes (3) have non-uniform minimum hole widths, w.

11. The lithography pattern generation system (1) of any of claims 1 to 10, wherein the through holes (3) have a minimum hole width (w) of 5nm, 4nm, 3nm, 2nm or 1nm.

12. The lithography pattern generation system (1) of any of claims 1 to 11, wherein the through holes (3) have a maximum hole width of 100 nm.

13. The lithography pattern generation system (1) of any of any of claims 1 to 12, wherein the through holes (3) have different shapes.

14. The lithography pattern generation system (1) of any of claims 1 to 13, wherein the centre-to-centre distance between neighbouring through holes (3) is non-uniform.

15. The lithography pattern generation system (1) of any of claims 1 to 14, wherein the mask thickness is below 500 nm, 100 nm, 50nm, 20 nm, 10 nm or 7 nm.

16. The lithography pattern generation system (1) of any of claims 1 to 15, wherein the mask thickness is less than the minimum hole width, w.

17. The lithography pattern generation system (1) of any of claims 1 to 16, wherein the wavelength, $\lambda$, is smaller than any of the minimum feature-size, df, minimum pitch, minimum hole width, w, and mask thickness.

18. The lithography pattern generation system (1) of any of claims 1 to 17, wherein the wavelength, $\lambda$, is below 1.0 nm or 0.5 nm.

19. A method for generating a pattern (51) by lithography comprising;

- exposing a mask (4) comprising through holes (3) to an incoming particle beam (21) with a wavelength, $\lambda$, from a particle source (2), wherein particles in the incoming particle beam (21) arrive at the mask (4) in a particle wave, and wherein the mask (4) is configured to induce a phase shift of the particle wave as it propagates through the mask,
- arranging the mask (4) in front of a pattern target (5) and generating the pattern (51) on the pattern target (5), wherein the pattern target (5) is arranged a target distance, L2, from the mask, the through holes (3) have a minimum hole width, w, and the mask (4) has a mask extension, a, between the through holes (3) exposed by the incoming particle beam (21), **characterized in that** L2 $\leq$ wa/$\lambda$ .

**Patentansprüche**

1. Lithographiemustererzeugungssystem (1), umfassend

- einen einfallenden Partikelstrahl (21) mit einer Wellenlänge, $\lambda$, von einer Partikelquelle (2) und
- eine Maske (4) mit Durchgangslöchern (3), die in dem einfallenden Partikelstrahl (21) angeordnet sind, wobei das Lithographiemustererzeugungssystem (1) so konfiguriert ist, dass es ein Muster (51) auf einem Musterziel (5) erzeugt, wobei Partikel in dem einfallenden Partikelstrahl (21) in einer einfallenden Partikelwelle auf die Maske (4) treffen und wobei die Maske (4) so konfiguriert ist, dass sie Phasenverschiebungen über eine Wellenfront der Partikelwelle induziert, wenn diese sich durch die Maske ausbreitet, wobei das Lithographiemustererzeugungssystem (1) so konfiguriert ist, dass es das Muster (51) in einem Zielabstand, L2, von der Maske (4) auf der gegenüberliegenden Seite des einfallenden Partikelstrahls (21) erzeugt, wobei die Durchgangslöcher (3) eine minimale Lochbreite, w, aufweisen und die Maske (4) eine Maskenerweiterung, a, aufweist, die der maximale Abstand zwischen zwei Durchgangslöchern in der Maske (4) ist, die durch den einfallenden Partikelstrahl (21) belichtet werden, **dadurch gekennzeichnet, dass** L2 $\leq$ wa/$\lambda$ ist.

2. Lithografiemustererzeugungssystem (1) nach Anspruch 1, wobei die induzierte Phasenverschiebung mindestens $\pi$, 3/2$\pi$ oder 5/3$\pi$ für einen Abstand beträgt, der dem 0,016-fachen der minimalen Lochbreite, w, der Durchgangslöcher (3) von der Maske (4) entspricht.

3. Lithographiemustererzeugungssystem (1) nach einem der Ansprüche 1 bis 2, wobei die Maske (4) mit neutralen Partikeln, Ionen und Elektronen dotiert oder implantiert ist, um die Wechselwirkung der Dispersionskräfte zu modifizieren und die Phasenverschiebungen über die Wellenfront zu modifizieren.

4. Lithographiemustererzeugungssystem (1) nach einem der Ansprüche 1 bis 3, das konfiguriert ist, um das Hintergrundsignal stärker als die Beugungsordnungen im Vergleich zur Beugung einer optischen Welle zu reduzieren, die sich mit derselben Wellenlänge durch dieselbe Maske (4) in einer Richtung axial durch ein Durchgangsloch (3) ausbreitet, um den Bruchteil des Strahls zu erhöhen, der gebeugt wird, anstatt gerade durch den Kontrast, c, des Musters (51) hindurchzugehen.

5. Lithographiemustererzeugungssystem nach einem der Ansprüche 1 bis 4, wobei die Partikelquelle (2) einen Öffnungsdurchmesser, da, aufweist, der kleiner ist als ein Quellenabstand, L1, zwischen der Partikelquelle (2) und der Maske (4).

6. Lithographiemustererzeugungssystem nach einem der Ansprüche 1 bis 5, wobei die Maskenerweiterung (a) kleiner ist als ein Quellenabstand, L1, zwischen der Partikelquelle (2) und der Maske (4).

7. Lithographiemustererzeugungssystem (1) nach einem der Ansprüche 1 bis 6, wobei die minimale Lochbreite, w, mindestens zweimal, dreimal oder viermal so groß ist wie eine minimale Strukturgröße des Musters (51).

8. Lithographiemustererzeugungssystem (1) nach einem der Ansprüche 1 bis 7, wobei die Maske (4) eine binäre Holografiemaske ist.

9. Lithographiemustererzeugungssystem (1) nach einem der Ansprüche 1 bis 8, wobei die Durchgangslöcher (3) in nicht-periodischen Positionen auf der Maske (4) angeordnet sind, nicht nach einer vordefinierten zugrunde liegenden periodischen Gitterstruktur.

10. Lithographiemustererzeugungssystem (1) nach einem der Ansprüche 1 bis 9, wobei die Durchgangslöcher (3) uneinheitliche minimale Lochbreiten, w, aufweisen.

11. Lithographiemustererzeugungssystem (1) nach einem der Ansprüche 1 bis 10, wobei die Durchgangslöcher (3) eine minimale Lochbreite (w) von 5 nm, 4 nm, 3 nm, 2 nm oder 1 nm aufweisen.

12. Lithographiemustererzeugungssystem (1) nach einem der Ansprüche 1 bis 11, wobei die Durchgangslöcher (3) eine maximale Lochbreite von 100 nm aufweisen.

13. Lithographiemustererzeugungssystem (1) nach einem der Ansprüche 1 bis 12, wobei die Durchgangslöcher (3) unterschiedliche Formen aufweisen.

14. Lithographiemustererzeugungssystem (1) nach einem der Ansprüche 1 bis 13, wobei der Mittenabstand zwischen benachbarten Durchgangslöchern (3) uneinheitlich ist.

15. Lithographiemustererzeugungssystem (1) nach einem der Ansprüche 1 bis 14, wobei die Maskendicke unter 500 nm, 100 nm, 50 nm, 20 nm, 10 nm oder 7 nm liegt.

16. Lithographiemustererzeugungssystem (1) nach einem der Ansprüche 1 bis 15, wobei die Maskendicke geringer ist als die minimale Lochbreite, w.

17. Lithographiemustererzeugungssystem (1) nach einem der Ansprüche 1 bis 16, wobei die Wellenlänge, $\lambda$, kleiner ist als irgendeine der minimalen Strukturgrößen, df, minimalen Teilungen, minimalen Lochbreiten, w, und Maskendicken.

18. Lithographiemustererzeugungssystem (1) nach einem der Ansprüche 1 bis 17, wobei die Wellenlänge, $\lambda$, unter 1,0 nm oder 0,5 nm ist.

19. Verfahren zum Erzeugen eines Musters (51) durch Lithografie, umfassend:

   - Belichten einer Maske (4), umfassend Durchgangslöcher (3) mit einem einfallenden Partikelstrahl (21) mit einer Wellenlänge, $\lambda$, von einer Partikelquelle (2), wobei Partikel in dem einfallenden Partikelstrahl (21) in einer Partikelwelle auf der Maske (4) ankommen und wobei die Maske (4) so konfiguriert ist, dass sie eine Phasenverschiebung der Partikelwelle induziert, wenn diese sich durch die Maske ausbreitet,
   - Anordnen der Maske (4) vor einem Musterziel (5) und Erzeugen des Musters (51) auf dem Musterziel (5), wobei das Musterziel (5) in einem Zielabstand, L2, von der Maske angeordnet ist, die Durchgangslöcher (3) eine minimale Lochbreite, w, aufweisen, und die Maske (4) eine Maskenerweiterung, a, zwischen den von dem einfallenden Partikelstrahl (21) belichteten Durchgangslöchern (3) aufweist, **dadurch gekennzeichnet, dass** L2 ≤ wa/$\lambda$ ist.

## Revendications

1. Système de génération de motifs par lithographie (1) comprenant

   - un faisceau de particules incident (21) ayant une longueur d'onde, $\lambda$, provenant d'une source de particules (2), et

- un masque (4) comprenant des trous traversants (3) disposés dans le faisceau de particules incident (21), dans lequel le système de génération de motifs par lithographie (1) est configuré pour générer un motif (51) sur une cible de motif (5), dans lequel des particules dans le faisceau de particules incident (21) arrivent au masque (4) sous la forme d'une onde de particules incidente, et dans lequel le masque (4) est configuré pour induire des déphasages à travers un front d'onde de l'onde de particules lorsqu'elle se propage à travers le masque, dans lequel le système de génération de motifs par lithographie (1) est configuré pour générer le motif (51) à une distance cible, L2, du masque (4) sur le côté opposé du faisceau de particules incident (21), dans lequel les trous traversants (3) présentent une largeur minimale de trou, w, et le masque (4) présente une extension de masque, a, qui est la distance maximale entre deux trous traversants dans le masque (4) exposés par le faisceau de particules incident (21), **caractérisé en ce que** $L2 \leq wa/\lambda$.

2. Système de génération de motifs par lithographie (1) de la revendication 1, dans lequel le déphasage induit est d'au moins $\pi$, $3/2\pi$ ou $5/3\pi$ pour une distance de 0,016 fois une largeur minimale de trou, w, des trous traversants (3) à partir du masque (4).

3. Système de génération de motifs par lithographie (1) de l'une quelconque des revendications 1 à 2, dans lequel le masque (4) est dopé ou implanté avec l'un quelconque parmi des particules neutres, ions et électrons afin de modifier l'interaction des forces de dispersion pour modifier les déphasages à travers le front d'onde.

4. Système de génération de motifs par lithographie (1) de l'une quelconque des revendications 1 à 3, configuré pour réduire le signal de fond plus fortement que les ordres de diffraction par rapport à la diffraction d'une onde optique se propageant avec la même longueur d'onde à travers le même masque (4) dans une direction de manière axiale à travers un trou traversant (3), afin d'augmenter la fraction du faisceau qui est diffractée plutôt que de passer directement à travers le contraste, c, du motif (51).

5. Système de génération de motifs par lithographie de l'une quelconque des revendications 1 à 4, dans lequel la source de particules (2) présente un diamètre d'ouverture, da, qui est inférieur à une distance de source, L1, entre la source de particules (2) et le masque (4).

6. Système de génération de motifs par lithographie de l'une quelconque des revendications 1 à 5, dans lequel l'extension de masque (a) est inférieure à une distance de source, L1, entre la source de particules (2) et le masque (4).

7. Système de génération de motifs par lithographie (1) de l'une quelconque des revendications 1 à 6, dans lequel la largeur minimale de trou, w, est au moins deux fois, trois fois ou quatre fois aussi grande qu'une taille minimale de caractéristique du motif (51).

8. Système de génération de motifs par lithographie (1) de l'une quelconque des revendications 1 à 7, dans lequel le masque (4) est un masque d'holographie binaire.

9. Système de génération de motifs par lithographie (1) de l'une quelconque des revendications 1 à 8, dans lequel les trous traversants (3) sont disposés à des positions non périodiques sur le masque (4), et non selon une structure de grille périodique sous-jacente prédéfinie.

10. Système de génération de motifs par lithographie (1) de l'une quelconque des revendications 1 à 9, dans lequel les trous traversants (3) présentent des largeurs minimales de trou, w, non uniformes.

11. Système de génération de motifs par lithographie (1) de l'une quelconque des revendications 1 à 10, dans lequel les trous traversants (3) présentent une largeur minimale de trou (w) de 5 nm, 4 nm, 3 nm, 2 nm ou 1 nm.

12. Système de génération de motifs par lithographie (1) de l'une quelconque des revendications 1 à 11, dans lequel les trous traversants (3) présentent une largeur maximale de trou de 100 nm.

13. Système de génération de motifs par lithographie (1) de l'une quelconque des revendications 1 à 12, dans lequel les trous traversants (3) présentent des formes différentes.

14. Système de génération de motifs par lithographie (1) de l'une quelconque des revendications 1 à 13, dans lequel la distance centre-à-centre entre des trous traversants (3) voisins est non uniforme.

**15.** Système de génération de motifs par lithographie (1) de l'une quelconque des revendications 1 à 14, dans lequel l'épaisseur de masque est inférieure à 500 nm, 100 nm, 50 nm, 20 nm, 10 nm ou 7 nm.

**16.** Système de génération de motifs par lithographie (1) de l'une quelconque des revendications 1 à 15, dans lequel l'épaisseur de masque est inférieure à la largeur minimale de trou, w.

**17.** Système de génération de motifs par lithographie (1) de l'une quelconque des revendications 1 à 16, dans lequel la longueur d'onde, λ, est inférieure à l'un quelconque parmi la taille minimale de caractéristique, df, le pas minimal, la largeur minimale de trou, w, et l'épaisseur de masque.

**18.** Système de génération de motifs par lithographie (1) de l'une quelconque des revendications 1 à 17, dans lequel la longueur d'onde, λ, est inférieure à 1,0 nm ou 0,5 nm.

**19.** Procédé de génération d'un motif (51) par lithographie comprenant :

- l'exposition d'un masque (4) comprenant des trous traversants (3) à un faisceau de particules incident (21) ayant une longueur d'onde, λ, provenant d'une source de particules (2), dans lequel des particules du faisceau de particules incident (21) arrivent au masque (4) sous la forme d'une onde de particules, et dans lequel le masque (4) est configuré pour induire un déphasage de l'onde de particules lorsqu'elle se propage à travers le masque,
- la disposition du masque (4) devant une cible de motif (5) et la génération du motif (51) sur la cible de motif (5), dans lequel la cible de motif (5) est disposée à une distance cible, L2, du masque, les trous traversants (3) présentent une largeur minimale de trou, w, et le masque (4) présente une extension de masque, a, entre les trous traversants (3) exposés par le faisceau de particules incident (21), **caractérisé en ce que** L2 ≤ wa/λ.

Fig. 1 (Prior art)

Fig. 2

Fig. 3

Fig. 4

## Fig. 5.1

## Fig. 5.2

## Fig. 5.3

## Fig. 5.4

## Fig. 5.5

## Fig. 5.6

Fig. 6a

Fig. 6b

Fig. 6c

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WILBUR, J.L** ; **GILLASPY, J.D.** ; **HELG, A.G.** ; **MCCLELLAND, J.J** ; **ROLSTON, S.L.** ; **PHILLIPS, W.D.** ; **PRENTISS, M** ; **WHITESIDES, G.M.** Microlithography by Using Neutral Metastable Atoms and Self-Assembled Monolayers. *Science*, 1995, vol. 269 (5228), 1255-1257, https://arxiv.org/abs/https://www.science.org/doi/pdf/10.1126/science.7652572. https://doi.org/10.1126/science.7652572
- **FUJITA, J.** ; **MORINAGA, M.** ; **KISHIMOTO, T.** ; **YASUDA, M.** ; **MATSUI, S** ; **SHIMIZU, F**. Manipulation of an atomic beam by a computer-generated hologram. *Nature*, 1996, vol. 380 (6576), 691-694, https: https://doi.org/10.1038/380691a0

- **NESSE, T.** ; **SIMONSEN, I** ; **HOLST, B.** Nanometer-Resolution Mask Lithography with Matter Waves: Near-Field Binary Holography. *Phys. Rev.*, 2019, vol. 11, 024009, https://doi.org/10.1103/PhysRevApplied.11.024009
- Realistic mask generation for matter-wave lithography via machine learning. **JOHANNES FIEDLER et al.** ARXIV.ORG. CORNELL UNIVERSITY LIBRARY, 15 July 2022, 14853
- An atom passing through a hole in a dielectric membrane: impact of dispersion forces on mask-based matter-wave lithography. **FIEDLER JOHANNES et al.** JOURNAL OF PHYSICS B, ATOMIC MOLECULAR AND OPTICAL PHYSICS. INSTITUTE OF PHYSICS PUBLISHING, 10 February 2022, vol. 55